# FASCICULE DE BREVET EUROPEEN

(11) **EP 2 963 746 B1**
(45) Date de publication et mention de la délivrance du brevet: **05.08.2020**
(21) Numéro de dépôt: 15170072.1
(22) Date de dépôt: 01.06.2015
(51) Int. Cl.: H02B 1/052, H02B 7/06, H02J 13/00, H02B 1/04

(54) **MODULE D'ALIMENTATION POUR EQUIPEMENT MODULAIRE DE TELE-CONDUITE ET EQUIPEMENT LE COMPRENANT**
NETZMODUL FÜR MODULARE AUSSTATTUNG ZUM FERNWIRKEN, UND AUSSTATTUNG DIE DIESES MODUL UMFASST
POWER SUPPLY MODULE FOR MODULAR TELECONTROL EQUIPMENT AND EQUIPMENT COMPRISING SAME

(30) Priorité: 02.07.2014 FR 1456312
(43) Date de publication de la demande: 06.01.2016
(73) Titulaire: Schneider Electric Industries SAS, 92500 Rueil-Malmaison (FR)
(72) Inventeur: SINISTRO, Stéphane, 38050 GRENOBLE (FR); MOLLIER, Christophe, 38050 GRENOBLE (FR); SUPTITZ, Eric, 38050 GRENOBLE (FR)

(56) Documents cités:
- WO-A1-2015/144265
- DE-U1- 29 721 012
- BERND SCHÜPFERLING ET AL: "INTELLIGENT TRANSFORMER SUBSTATIONS IN MODERN MEDIUM VOLTAGE NETWORKS AS PART OF "SMART GRID"", 21ST INTERNATIONAL CONFERENCE ON ELECTRICITY DISTRIBUTION, 9 juin 2011 (2011-06-09), XP055173123,
- Anonymous: "RTU and special electronics", ELVAC , 20 juin 2014 (2014-06-20), XP002739189, Extrait de l'Internet: URL:http://www.elvac.eu/ipc/download/ELVAC -IPC-RTU-EN.pdf [extrait le 2015-05-04]
- Anonymous: "RTU560 product line", ABB , 30 juin 2014 (2014-06-30), XP002739190, Extrait de l'Internet: URL:https://web.archive.org/web/2014063009 5421/http://www05.abb.com/global/scot/scot 258.nsf/veritydisplay/b9ede8641147035cc125 7b26004042d1/$file/2013-03-06-RTU560-produ ct-line.pdf [extrait le 2015-05-04]
- Anonymous: "RTU and PLC uninterruptible power supply systems", Solarcraft , 30 avril 2014 (2014-04-30), XP002739191, Extrait de l'Internet: URL:http://solarcraft.net/media/files/file s/267ba336/RTU-PLC-UPS.pdf [extrait le 2015-05-04]

## Description

### DOMAINE TECHNIQUE

L'invention concerne l'architecture régissant l'agencement des différents composants d'une interface de télécommande d'interrupteurs. En particulier, l'invention se rapporte à un équipement de télé-conduite comprenant le module d'alimentation sur lequel se greffent des modules de communication et de surveillance ou contrôle/commande.

### ETAT DE LA TECHNIQUE

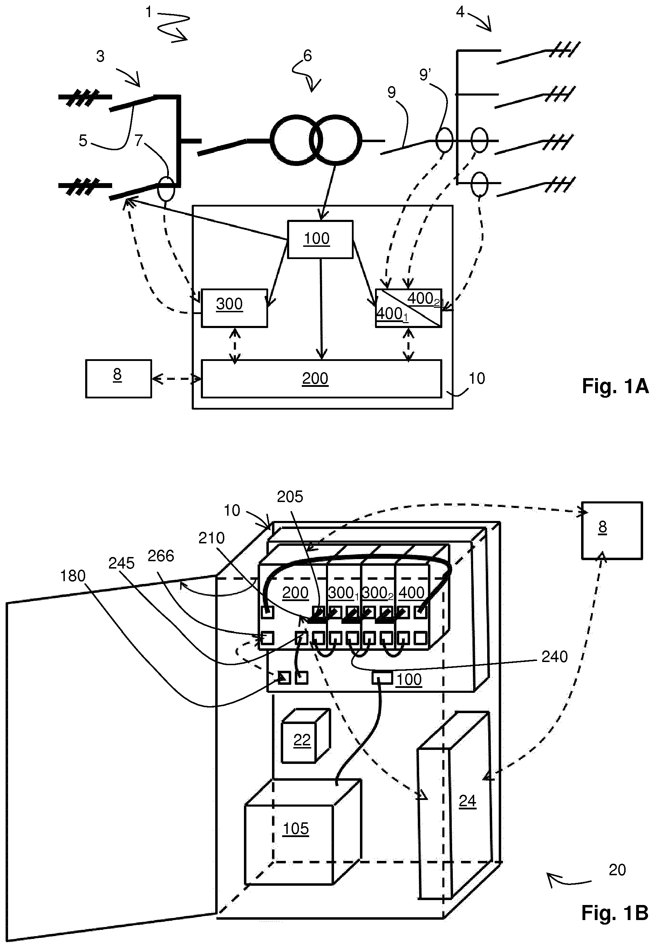

Les réseaux électriques 1 sont généralement architecturés en plusieurs niveaux, avec un premier réseau de transport et de répartition très haute et haute tensions depuis les centrales de production sur de grandes distances. Un réseau 3 de distribution moyenne tension HTA ou MT lui succède pour des transports à plus petite échelle, vers des clients de type industriels ou vers des réseaux 4 basse tension BT qui alimentent des clients de faible demande énergétique (voir aussi figure 1A).

Au niveau du réseau de distribution 3 usuellement entre 1 et 35 kV, et plus précisément 15 ou 20 kV en France, il est usuel que les appareillages HTA 5 puissent être télécommandés à partir de postes distants 6, classiquement au niveau des postes de transformation MT/BT. Ainsi, Electricité de France (EdF) utilise des interfaces 10 de télécommande d'interrupteurs 400 A, ou ITI, pour commander jusque huit interrupteurs 5 en utilisant le réseau radio analogique ou numérique par GPRS (pour « *General Packet Radio Service* »), le réseau téléphonique commuté RTC, une liaison téléphonique dédiée (ou liaison spécialisée LS), ou autres types de réseaux informatiques.

Un ITI 10, alimenté directement sur le réseau alternatif BT 4, permet donc la télécommunication avec le poste de conduite de réseau 6, la manœuvre des commandes électriques des interrupteurs 5, la détection des défauts HTA, l'ouverture automatique d'un interrupteur 5 sur détection du départ en défaut, la permutation automatique des sources d'alimentation, l'enregistrement des manœuvres et la signalisation des événements datés. De plus, l'ITI 10 doit assurer ces fonctions dites principales en cas de perte de la source alternative d'alimentation ; à cette fin, il comprend une source autonome d'alimentation qui vient suppléer la source usuelle alternative extérieure.

Plus généralement, ce type d'équipement 10 dit « de télé-conduite », ou FRTU (selon la terminologie anglo-saxonne « *Feeder automation Remote Terminal Unit* ») est localisé au niveau des sous-stations MT/BT 6 et assure des fonctions de mesure, communication et contrôle, étant relié en aval à des capteurs 7, et en amont à un superviseur de télégestion 8 de type SCADA (pour « *Supervisory Control And Data Acquisition* »).

Des cahiers des charges régissent les éléments constitutifs des équipements de télé-conduite, qui peuvent varier notamment en raison de l'environnement du réseau (souterrain/aérien), de sa densité (nombre de départs à surveiller), de sa mise à la terre, des possibilités de communication (radio, GSM...), des spécificités des capteurs ou des contraintes d'encombrement, sans compter les exigences normatives locales. Il apparaît ainsi souhaitable d'avoir une offre modulaire permettant de composer l'équipement de télé-conduite 10 correspondant au mieux aux besoins du client, ce qui facilite entre autres la gestion technique et la logistique, tout en permettant une adaptation éventuelle. Il apparaît alors souhaitable de faciliter les raccordements entre les modules d'une telle offre.

Par ailleurs, l'insertion de moyens de production décentralisée, avec les panneaux photovoltaïques, fermes éoliennes et microcentrales, dans les réseaux BT 4 et les réseaux MT 3 augmente considérablement leur complexité, avec une distribution énergétique bidirectionnelle et inconstante dont il convient de gérer les fluctuations paramétriques. En particulier, outre les fonctions de détection de défauts et contrôle du réseau MT 3, il serait souhaitable d'étendre les fonctionnalités d'un FRTU 10 à la gestion du plan de tension moyenne tension 3 et la gestion du réseau BT 4. La publication "INTELLIGENT TRANSFORMER SUBSTATIONS IN MODERN MEDIUM VOLTAGE NETWORKS AS PART OF "SMART GRID", 21st INTERNATIONAL CONFERENCE ON ELECTRICITY DISTRIBUTION" par Schüpferling, Riemenschneider et Opitsch illustre l'état de la technique.

### EXPOSE DE L'INVENTION

Parmi autres avantages, l'invention vise à proposer une configuration spécifique d'un des modules d'un équipement de télé-conduite, l'alimentation, de façon à offrir une architecture modulaire optimisée.

Sous un de ses aspects, l'invention concerne un module d'alimentation, ou atelier d'énergie, pour un équipement de télé-conduite, dont le boîtier est adapté pour servir de support à des appareils électroniques qu'il alimente. Le module d'alimentation comprend des moyens électroniques d'alimentation, en particulier une carte de circuit imprimé, qui comprennent notamment des moyens de raccordement à un réseau basse tension et à une batterie comme source auxiliaire, des moyens pour transformer l'énergie des sources auxquelles le module peut être raccordé en énergie d'alimentation pour des appareils électroniques, et des moyens de raccordement vers des appareils électroniques pour les alimenter, ainsi qu'éventuellement un port de communication et/ou des moyens de visualisation de type diodes électroluminescentes.

Les moyens électroniques d'alimentation sont logés dans un boîtier du module qui comprend une face de support, notamment métallique, destinée à être fixée sur un support mural, par exemple grâce à des moyens appropriés de fixation à des rails DIN, comme des moyens d'encliquetage sur un rail et des moyens de verrouillage sur un rail parallèle ; la carte de circuit imprimé est de préférence mise en place parallèlement à la face de support.

Le boîtier est fermé pour partie par un capot, de préférence isolant, comprenant des orifices depuis lequel sont accessibles les moyens de raccordement et visualisation, et pour l'autre partie, par un couvercle, avantageusement métallique, présentant une face avant opposée à la face de support qui est dotée de moyens de fixation pour des appareils électroniques alimentés, notamment un rail DIN ; des moyens d'isolation peuvent alors être prévus pour isoler les moyens électroniques du boîtier. Des ouïes de ventilation sont de préférence présentes sur deux parois latérales du couvercle pour permettre une convexion naturelle de refroidissement.

Sous un autre aspect, l'invention concerne un équipement de télé-conduite dont l'alimentation est assurée par un tel module. L'équipement de télé-conduite comprend ainsi en outre au moins un module de surveillance d'un réseau moyenne tension. L'équipement peut également comprendre un module de communication, lui aussi mis en place, via les moyens de fixation, sur la face avant du module d'alimentation auquel il est raccordé par les moyens de raccordement, le module de communication étant relié au module de surveillance de sorte que la liaison entre le module de surveillance et le module d'alimentation est sous forme de « *daisy chain* » via le module de communication. Avantageusement, le module d'alimentation et le module de communication sont en outre reliés via un port de communication.

### BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.
Les figures 1A et 1B illustrent schématiquement un équipement de télé-conduite selon un mode de réalisation préféré de l'invention et sa localisation dans un réseau électrique.
Les figures 2A et 2B représentent un cavalier de connexion.
Les figures 3A, 3B et 3C montrent les différents éléments pour un atelier d'énergie d'un équipement de télé-conduite selon un mode de réalisation préféré de l'invention.
La figure 4 montre la forme générale d'un boîtier de module d'équipement de télé-conduite selon un mode de réalisation préféré de l'invention.
Les figures 5A et 5B représentent un module de communication d'équipement de télé-conduite selon un mode de réalisation préféré de l'invention.
Les figures 6 et 7 montrent des modules de surveillance pour le réseau MT et BT pour un équipement de télé-conduite selon un mode de réalisation préféré de l'invention.
La figure 8 illustre schématiquement un équipement selon un mode de réalisation de l'invention mis en place au niveau d'un poste MT/BT à surveiller.

### DESCRIPTION DETAILLEE D'UN MODE DE REALISATION PREFERE

Par simplification de la description, les différents éléments seront décrits en relation avec une position d'utilisation de l'équipement 10, monté dans un coffret 20 au niveau du poste MT/BT 6 sur une paroi verticale. Il est cependant entendu que les termes de position tels que « horizontal », « latéral », «fond» ne sont nullement restrictifs quant à l'objet de l'invention. Par ailleurs, les termes géométriques, tels que «orthogonal »,... doivent se comprendre dans leur acceptation mécanique, c'est-à-dire tolérant un écart par rapport à la définition mathématique stricte : par exemple, un « rectangle » peut, selon l'invention, être bombé et avoir des angles émoussés différant légèrement de 90°.

Tel qu'illustré en figures 1A, un équipement 10 de télé-conduite comprend un premier module 100 destiné à son alimentation, un deuxième module 200 servant d'interface de communication et au moins un troisième module 300 destiné à la surveillance, ou contrôle/commande, du réseau moyenne tension MT 3. De plus, l'équipement 10 peut comprendre au moins un quatrième module 400ᵢ destiné à la surveillance du réseau basse tension BT 4, utilisant le même module 200 de communication que le(s) module(s) 300ᵢ de surveillance MT. Selon le mode de réalisation préféré de l'invention, chaque module 100, 200, 300, 400 est formé d'un boîtier individuel logeant les éléments fonctionnels et peut ainsi être dissocié des autres, par exemple pour remplacement ; les modules 100, 200, 300, 400 sont reliés entre eux avec des moyens adaptés pour assurer la communication et la fourniture d'énergie.

L'équipement de télé-conduite 10 est, comme aussi illustré en figure 1B, classiquement mis en place dans un coffret dédié 20, même si d'autres options sont possibles. Un coffret 20 est partiellement normalisé en ce qui concerne notamment ses dimensions et les éléments qu'il doit loger, lesdits éléments imposant pour leur part certaines contraintes d'isolement relatif : voir par exemple la demande de brevet FR 13 56645. En particulier, le coffret 20 loge une batterie 105, usuellement en bas du coffret pour des raisons de poids, un porte-fusibles 22, une communication externe de type radio 24, et l'équipement de télé-conduite 10.

Avantageusement, l'équipement de télé-conduite 10 est localisé en haut de coffret 20 et forme une rangée, les modules de communication 200 et surveillance 300, 400 notamment étant alignés côte à côte. De préférence, les profils des modules alignés sont similaires pour former un ensemble cohérent, avec une largeur identique ou multiple d'un pas fixe, de façon à faciliter leur assemblage, le passage des câbles, les raccordements, ainsi que l'accès et la visualisation des interfaces.

Dans un mode de réalisation préféré, le module de communication 200 est localisé à une extrémité de l'alignement, par exemple pour faciliter ses raccordements vers les systèmes 8 de gestion externe comme une centrale SCADA. Comme le module de communication 200 doit être relié fonctionnellement aux autres modules 100, 300, 400 du FRTU 10, et afin de simplifier ces raccordements, il est préféré d'utiliser une connexion en série ou de type *« daisy chain* », c'est-à-dire que la transmission d'information pour la communication se fait de proche en proche depuis le module de communication 200, par l'intermédiaire de moyens adaptés 210, par exemple une connectique de préférence de type RJ45. Cette solution offre pour avantage supplémentaire la possibilité de rajouter / retirer des modules de surveillance 300ᵢ, 400ᵢ sans limite. Dans le mode de réalisation préféré dans lequel les modules de surveillance 300ᵢ, 400ᵢ et communication 200 sont placés côte à côte, il est avantageux que les bornes de connexion 205 de chaque module 200, 300, 400 soient placées à écart identique du bord de leur boîtier, de sorte que la distance les séparant soit constante, par exemple de 26 mm. Ainsi, il est possible de prévoir des moyens de connexion 210 adaptés, dont les deux connecteurs 212 sont reliés par une longueur optimisée de cuivre qui offre en outre un aspect externe dénué de câbles pendants.

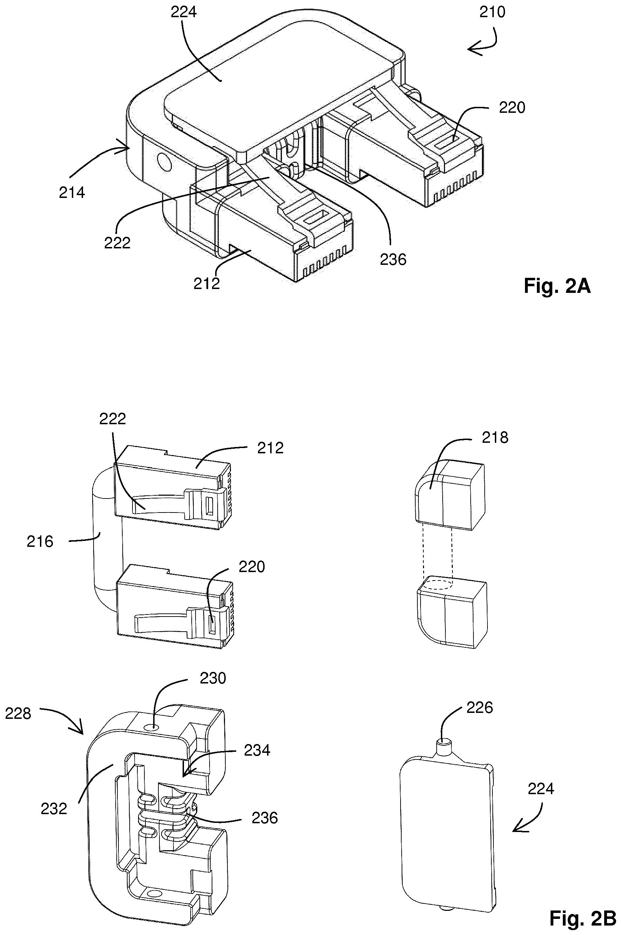

Dans un mode de réalisation préféré illustré en figures 2, la connectique 210 de raccordement daisy chain est rigide, sous forme de cavaliers. Les deux connecteurs 212 sont ainsi reliés par une base en U 214, comprenant notamment un cœur en câble gainé 216, notamment 8 brins si les connecteurs 212 sont des bornes RJ45. Pour diminuer au maximum la taille de la connectique 210, le rayon de courbure du câble 216 est augmenté, et des collecteurs 218 sont mis en place à l'extrémité de chaque connecteur 212 afin de protéger ledit câble 216 qui s'appuie sur son arête.

Tel qu'indiqué, la connexion Ethernet de type RJ45 est la plus appropriée pour la transmission d'informations au sein d'un équipement modulaire de télé-conduite 10. Le choix de réduire le plus possible la longueur de câble 216 génère cependant des difficultés dans la préhension des ports Ethernet mâles 212 qui comprennent un verrou 220 et un loquet 222 à pousser lors de l'extraction notamment. Selon le mode de réalisation préféré, les deux connecteurs 212 sont donc placés parallèlement l'un à l'autre, avec leur loquet 222 sur le même côté de la connectique 210, et un poussoir 224 est mis en place pour actionner les deux loquets 222 en même temps. Le poussoir 224 est de préférence mobilisable par pivotement autour d'un axe, qui est avantageusement formé intégralement avec le poussoir 224 en dépassant d'une plaque par deux ergots 226. Le poussoir 224 coopère avec un surmoulage 228 de la partie en U.

De fait, l'ensemble formé par l'extrémité des connecteurs 212, le câble 216 et les collecteurs 218 est surmoulé par un plastique, le surmoulage 228 étant muni de deux œillets 230, débouchant ou non, pour accueillir les ergots 226 du poussoir 224. En l'absence de sollicitations, le poussoir 224 est adjacent aux loquets 222 des ports Ethernet 212 sans y appuyer ; de préférence, une partie du poussoir 224 repose sur un plateau 232 formé dans le surmoulage, le surmoulage 228 formant par là un évidement 234 en dessous de l'autre partie du poussoir 224, située de l'autre côté de l'axe 226. Une pression sur le poussoir 224 du côté de l'évidement 234 entraîne un pivotement autour de l'axe 226 de sorte que ladite partie du poussoir 224, adjacente aux loquets 222, vient appuyer simultanément et identiquement sur les deux loquets 222 pour libérer les verrous mécaniques 220 des connecteurs RJ45, afin d'insérer ou d'extraire le cavalier 210 des modules adjacents entre lesquels il assure la liaison. L'opération est ainsi faite en une seule fois et avec une seule main.

De préférence, la partie surmoulée 228 de la connectique 210 comprend des moyens pour le rendre partiellement souple, notamment un soufflet 236. Cette souplesse permet par exemple d'insérer facilement les ergots 226 dans les œillets 230 lors de l'assemblage du cavalier 210, et d'ajuster éventuellement les connecteurs 212 lors de leur insertion dans les bornes 205 des modules pour accepter un léger décalage de niveau ou d'espacement entre les modules 200, 300, 400 côte à côte.

La connectique 210 présente pour avantage majeur sa facilité de mise en œuvre pour la connexion/déconnexion des modules entre eux du fait de l'actionnement simultané des deux loquets de raccordement 222. De plus, la configuration permet de limiter l'encombrement dû à la connexion entre modules 200, 300, 400 tout en permettant une bonne visualisation de la réalisation effective du raccordement. Il est entendu cependant que d'autres types de connexion peuvent être utilisés pour ce raccordement daisy chain du FRTU 10.

Chacun des modules de surveillance 300ᵢ, 400ᵢ et communication 200 est par ailleurs relié au module d'alimentation 100 pour la fourniture d'énergie. Le module d'alimentation 100 de l'équipement de télé-conduite 10 peut être adapté pour servir d'atelier d'énergie, conçu pour le contrôle et la commande de l'ensemble de la sous-station 6, y compris la motorisation des interrupteurs MT 5, voire BT 9. Comme pour tout équipement de télé-conduite, l'atelier d'énergie 100 est adapté pour s'alimenter sur le réseau BT 4 et sur une batterie 105 qu'il est apte à surveiller (niveau de charge, température...), notamment lorsque le réseau principal est en défaut, pour fournir simultanément plusieurs niveaux de tension, pour alimenter les différentes fonctions du FRTU 10 (communication, mesures, commandes des interrupteurs motorisés 5)... : des moyens électroniques, sous forme préférée de carte(s) de circuit imprimé, forment la partie fonctionnelle correspondante de l'atelier d'énergie 100.

Compte tenu des contraintes de volume et de masse d'un tel atelier d'énergie 100, notamment pour des puissances conséquentes imposant des dimensions minimales pour les transformateurs, les radiateurs, etc., un défi à relever est l'intégration dans le volume restreint imposé par certains prescripteurs pour les coffrets 20 logeant les appareils nécessaires à la télé-conduite. Selon l'invention, une autre solution que les alternatives connues (bloc d'alimentation massif indépendant, carte de gestion associée à un logement de batterie, ou module de faible puissance adjoint sur rail DIN comme dans la gamme iRIO) a été développée, afin de satisfaire les contraintes mécaniques (dimensions maximales de l'enveloppe du FRTU 10), thermiques (problématiques d'échauffement) et électromagnétiques (cohabitation de signaux électroniques de différents niveaux et à différentes fréquences) tout en s'intégrant dans l'offre modulaire 10 développée.

Ainsi, tel que schématisé en figure 1B, le module d'alimentation 100 selon le mode de réalisation préféré de l'invention est conçu pour servir de support à l'alignement des modules de communication 200 et surveillance 300, 400 : le module d'alimentation 100 est plat, posé parallèlement au support mural, par exemple fixé via un ou plusieurs rails DIN, et son boîtier 110 comprend en face avant des moyens destinés à supporter les autres modules 200, 300, 400 de l'équipement de télé-conduite 10. Notamment, le module d'alimentation 100 a une épaisseur inférieure à 85 mm, par exemple de 70-74 mm + 7 mm de rail de fixation, pour une emprise murale inférieure à 200 mm × 300 mm, par exemple 190 × 270 (± 1) mm². Ainsi, la perte de place est minimisée, les contraintes mécaniques pour le maintien de l'atelier d'énergie 100 sont faibles, la distribution des niveaux de tension est facilitée et non-limitée.

Par ailleurs, afin de garantir une bonne visibilité de son interface homme/machine et une bonne accessibilité des différentes connectiques, l'atelier d'énergie 100 comporte un bandeau fonctionnel d'interface 112, par exemple localisé en bas du boîtier 110. Pour augmenter la modularité et diminuer les raccordements, l'alimentation des modules 200, 300, 400 du FRTU 10 est également réalisée de proche en proche, via un daisy chain, similaire à la transmission d'information entre lesdits modules : seul un des modules, de préférence le module de tête de communication 200, est alimenté via un raccordement sur le bandeau fonctionnel 112, les autres l'étant par une connectique qui peut être couplée à celle de transmission de données ou, de préférence, séparée avec des câbles d'alimentation dédiés 240, éventuellement sous forme de cavaliers si les bornes d'alimentation 245 remplissent des critères similaires d'espacement que celles décrites pour les bornes de transmission 205.

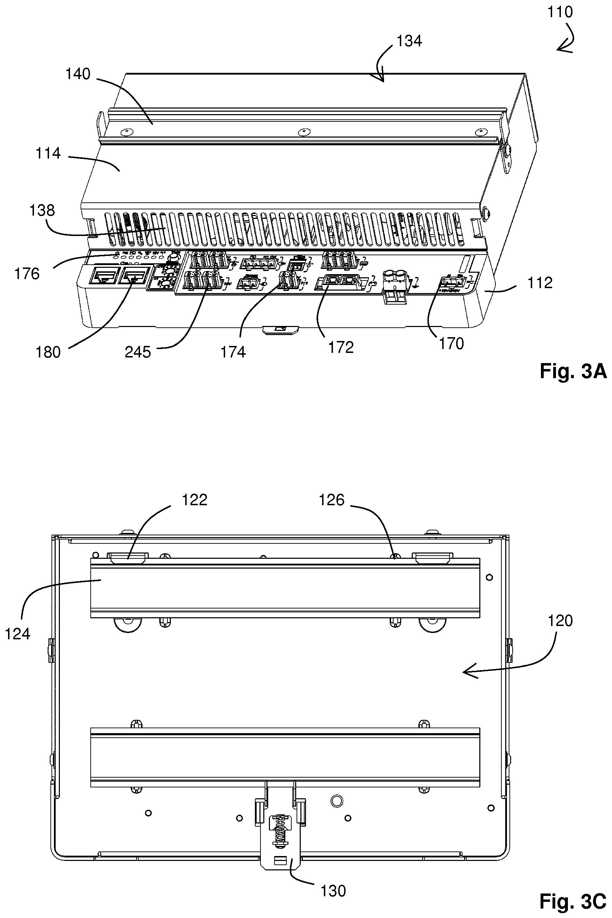

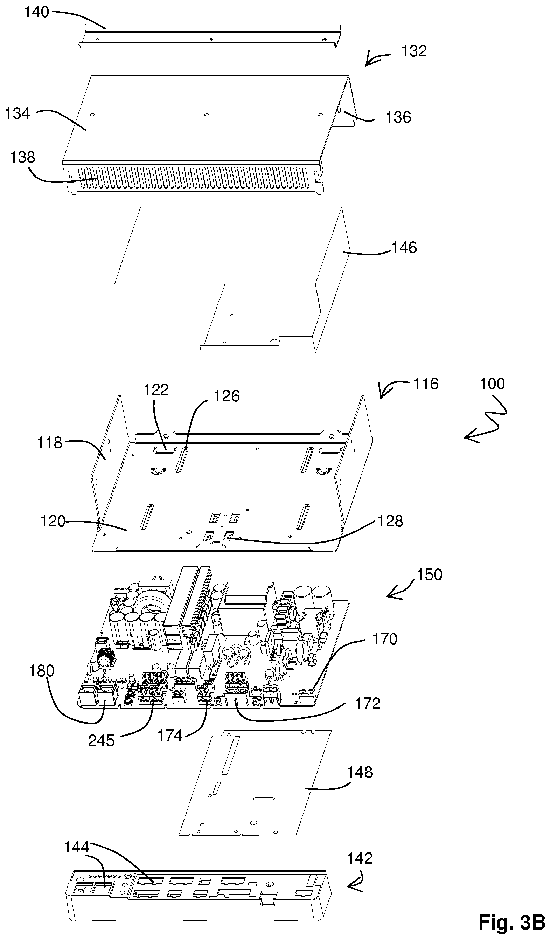

Dans un mode de réalisation préféré représenté en figures 3, le module d'alimentation 100 comprend ainsi un boîtier 110 en deux parties avec, outre le bandeau fonctionnel 112, une partie principale de logement 114 sensiblement parallélépipédique rectangle. Le boîtier comprend un socle 116, avantageusement une tôle pliée, formant les parois latérales 118 de la partie principale de logement 114 et la face arrière 120 du module 100. Ladite face arrière 120 est destinée à se fixer sur une paroi verticale, par exemple du coffret 20, et comprend avantageusement des emboutis 122 qui permettent de se crocheter sur un rail DIN 124, de préférence sur deux rails DIN horizontaux présents sur le support mural ; avantageusement, des bossages 126 sont également formés afin de s'appuyer sur lesdits rails 124 pour permettre un positionnement parallèle à la paroi, et/ou des orifices 128 sont adaptés pour accueillir un verrouillage 130 sur un des rails DIN 124 au moins.

Le boîtier 110 est fermé par un premier couvercle 132, notamment en tôle pliée, formant la face avant 134 d'accueil des autres modules 200, 300, 400 et les faces supérieure et inférieure 136 de la partie principale de logement 114. Les faces supérieure et inférieure 136 sont chacune dotées d'ouïes de ventilation 138, ce qui optimise la convexion naturelle et le refroidissement des composants d'alimentation logés dans le boîtier 110 ; la face avant 134 est munie de moyens de fixation des autres modules 200, 300, 400 de l'équipement 100, avantageusement un rail DIN 140.

Le boîtier 110 au niveau du bandeau d'interface fonctionnel 112 est fermé par un deuxième capot 142 muni des orifices 144 nécessaires à la mise en place des connecteurs et éléments de visualisation de l'interface homme/machine ; au vu de cette configuration, il est entendu que la face inférieure du premier capot 132 est plus étroite que la face supérieure. Le deuxième capot 142 est avantageusement en matière isolante ou plastique afin de garantir l'isolation au niveau des connecteurs.

Le boîtier 110 loge les moyens pour transformer l'énergie reçue par le module 100, sous forme de circuit imprimé qui est isolé du capot métallique 132 par des moyens adaptés, notamment un isolateur de fond 146 doublant trois parois du boîtier 110 et un isolateur intermédiaire 148 augmentant les distances d'isolement, avantageusement en plastique. De préférence, les moyens nécessaires à assurer le fonctionnement de l'atelier d'alimentation 100 sont sous forme d'une seule carte de circuit imprimé 150 qui sera placée parallèlement au fond du socle 120 de l'équipement de télé-conduite 10, tous les éléments fonctionnels étant localisés sur une même surface de ladite carte 150 ce qui limite les contraintes mécaniques et de fabrication ; l'électronique mono-carte permet par ailleurs une gestion plus simple des références de composants et de leur schéma d'implantation.

La carte 150 porte les différents moyens nécessaires pour assurer le fonctionnement du module d'alimentation 100, ainsi que des éléments assurant des fonctions préférées, notamment pour le contrôle des paramètres. En particulier, la carte 150 comprend un transformateur d'isolement vis-à-vis de la BT, un circuit de redressement et de conversion pour fournir une tension 12 V DC à partir du 220 V AC, et un circuit de charge de la batterie 105. De plus, tel que requis, la carte 150 comprend des circuits de mesure et contrôle des courants et tensions d'entrée et de sortie. Avantageusement, la carte 150 comprend également un microprocesseur de supervision et un circuit chargeur permettant de fournir un courant différent, notamment aux interrupteurs MT 5, ainsi que les moyens adaptés à la surveillance de la batterie ainsi que des radiateurs ou autres éléments de refroidissement.

Ces éléments sont complétés par leur accès au niveau du capot d'interface 142 par :
- des moyens de connexion 170 vers une alimentation BT, notamment monophasée ;
- des moyens de connexion 172 vers une batterie 105 ;
- des moyens de connexion 245 pour distribuer l'alimentation, notamment 12 V, vers des appareils électroniques intelligents, ou IED pour «*Intelligent Electronic Device* », ici les autres modules de l'équipement, et en particulier le module de communication 200 ;
- des moyens de connexion 174 pour alimenter, notamment en 12 V, des équipements de communication normalisés, tels qu'une radio 24 ;
- des moyens de connexion pour une autre alimentation, notamment 24 ou 48 V, par exemple pour la motorisation des interrupteurs MT 5 ;
- des connecteurs vers des capteurs, par exemple une sonde de température ;
- des connecteurs vers des entrées/sorties ;
- des moyens de connexion dédiés pour un test de batterie sur charge externe ;
- des moyens d'adressage, par exemple par roue codeuse ;
- des diodes électroluminescentes 176 d'indication de statut (batterie, connexion d'un module à l'un des connecteurs,...).
En particulier, le module d'alimentation comprend un port 180 dédié à la communication directement avec le module de communication 200, notamment un connecteur pour liaison Modbus, qui peut par exemple permettre une mise à jour des processeurs de surveillance/contrôle ; suivant l'intégration ou non du module d'alimentation 100 dans la boucle de communication 210, une autre borne de communication RJ45 205 peut être prévue.

Le module d'alimentation 100 se présente ainsi sous forme plate, servant de support mécanique aux autres fonctions. La fixation en face arrière sur deux rails DIN 130 parallèles, l'un par crochetage, l'autre par verrouillage, permet de monter et démonter l'atelier d'énergie 100 sur son support sans outil spécifique. De plus, la présence d'ouïes 138 en haut et en bas du capot 132 permet une convection naturelle de l'atelier d'énergie 100, sans ventilateur, tout en garantissant l'indice de protection IP2x. Selon le niveau d'isolement par l'application, le prescripteur, le pays,... la face arrière 120 du module d'alimentation 100 peut être utilisée pour exploiter l'équipement en dissipateur thermique moyennant l'utilisation d'un joint thermique.

L'agencement des modules de communication 200 et surveillance 300, 400 sur le rail DIN 140 en face avant, ainsi que le bandeau de connectique 112 de l'atelier d'énergie 100 permettent des raccordements simplifiés, facilement accessibles et visuels, en concentrant toute la connectique dans la partie basse de l'alimentation. Comme les modules 200, 300, 400 nécessitent dans tous les cas une alimentation, le fait que cette dernière les supporte mécaniquement facilite leur intégration en définissant une architecture commune, y compris si l'option daisy chain n'est pas retenue. La superposition des modules 200, 300, 400 sur l'alimentation 100 dans le sens de la profondeur du coffret permet de gagner de la place par rapport aux solutions habituelles, étant donné l'exploitation de la profondeur, dimension la moins utilisée et qui permet de gagner du volume fonctionnel.

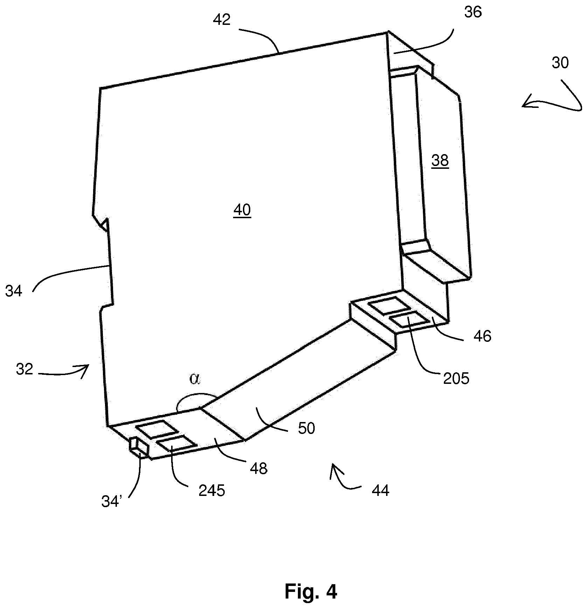

En particulier, les modules 200, 300, 400 présentent tous un profil similaire, basé sur celui des différents appareils électriques connus mis en place sur des rails DIN. Il apparaît cependant que les modules 200, 300, 400 doivent de préférence être adaptés pour montrer une interface homme/machine, et pour permettre un nombre conséquent de connexions. Notamment, tel qu'illustré en figure 4 et selon un mode de réalisation préféré, afin d'augmenter la surface de raccordement, le profil des boîtiers 30 de module 200, 300, 400 n'est pas rectangulaire, mais comprend une partie oblique.

Plus spécifiquement, la forme générale 30 des boîtiers de modules 200, 300, 400 comprend une paroi de fond 32 munie de moyens de fixation 34 sur un rail, notamment sur le rail DIN 140 du module d'alimentation 100, une paroi de face 36, opposée à la paroi de fond 32 et destinée à la visualisation des informations, notamment à accueillir l'interface homme/machine 38 du module, et deux parois latérales 40 similaires et destinées à être accolées entre elles. La paroi supérieure 42 peut être localisée directement sous la paroi d'un coffret 20 (voir figure 1B) et est de préférence horizontale. Tel que précisé plus haut, il est avantageux que la distance séparant deux parois latérales 40 de chaque boîtier 30 soit un multiple d'une même valeur, notamment pour respecter un pas de 45 mm ; par ailleurs, pour satisfaire les critères d'encombrement maximal des prescripteurs, et en tenant compte de l'épaisseur du module d'alimentation 100 qui s'y ajoute, il est préféré que la distance séparant la paroi de fond 32 de la paroi de face 36 soit inférieure à 140 mm ; la hauteur du boîtier, correspondant à celle de la paroi de fond 32, est avantageusement de l'ordre de 140 mm, ce qui laisse un accès suffisant au bandeau 112 du module d'alimentation 100, que ce soit pour les raccordements ou pour la visualisation de l'interface propre audit module 100.

La paroi inférieure 44 est plus précisément destinée aux raccordements. Afin d'augmenter sa surface et de faciliter lesdits raccordements, selon un mode de réalisation préféré, la paroi inférieure 44 est en trois parties. Une partie de front 46, sensiblement horizontale, est munie des bornes de connexion 205 pour le daisy chain, localisées de préférence à distance constante de leur bord respectif au niveau de l'arête avec la paroi latérale 40 : en particulier si les connecteurs 210 illustrés en relation avec les figures 2 sont utilisés, le raccordement est aisé. Une partie de fond 48, également sensiblement horizontale, comprend l'accès à une tirette de verrouillage 34' des moyens de fixation 34 sur un rail et les bornes de raccordement 245 pour l'alimentation. Entre la partie de fond 48 et la partie de front 46, la partie intermédiaire 50 est de préférence oblique, ce qui augmente sa longueur, et sert pour les raccordements propres aux modules 200, 300, 400.

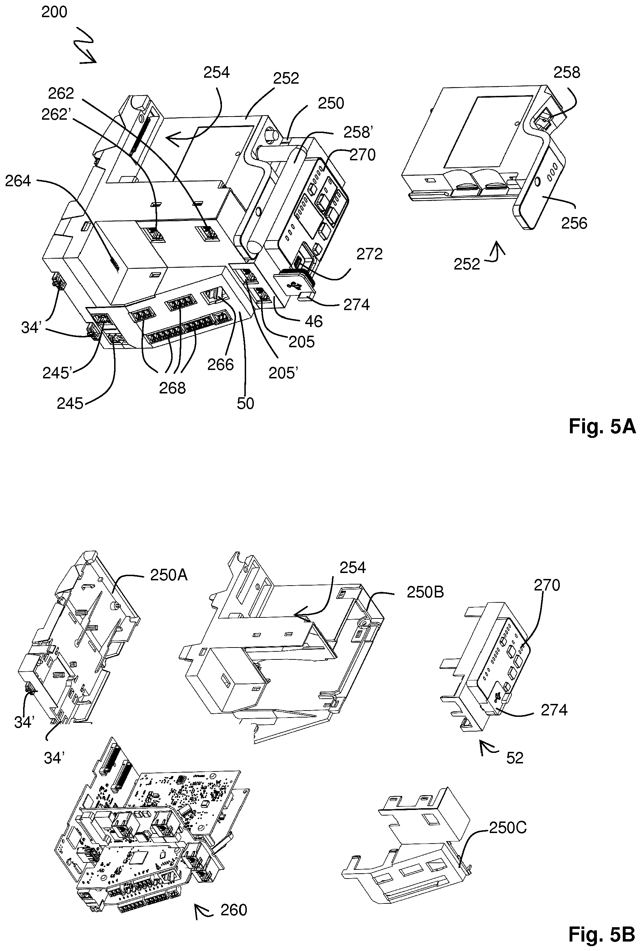

Le volume du boîtier 30 doit rester conséquent pour loger les différents éléments fonctionnels, et de préférence l'angle α entre la partie de fond 48 et la partie intermédiaire 50 de la paroi inférieure 44 est de l'ordre de 160°. La paroi frontale 36 est de longueur suffisante pour pouvoir y insérer une interface homme/machine 38 lisible, notamment de 77,5 mm de hauteur. Dans un mode de réalisation avantageux, la paroi de face 36 et l'interface homme/machine 38 font partie d'un ensemble fonctionnel, ou nez, 52 qui vient se clipser sur le reste du boîtier une fois celui-ci assemblé : voir aussi figure 5B.

Ainsi, dans le mode de réalisation préféré, deux rails DIN 124 convenablement espacés (par exemple avec un entraxe de 100 mm) tiennent lieu de support mural. L'atelier d'alimentation 100 vient se crocheter sur le rail supérieur et est ensuite fixé à l'aide d'un verrou 130 solidaire du socle métallique 116 du boîtier 110 sur le rail inférieur. Une fois fixé au support, le module d'alimentation 100 peut ensuite accueillir sur son rail DIN 140 situé en face avant 134 les différents modules 200, 300, 400 de l'équipement 10 selon l'invention.

Si le nombre de modules dépasse la capacité d'accueil dudit rail 140 (avantageusement de 6 fois le pas, soit un module 200 double et quatre modules de surveillance 300ᵢ, 400ᵢ), il est possible de rajouter un autre rail DIN directement sur le support mural, soit en prolongement du module d'alimentation 100, soit en dessous.

L'atelier d'énergie 100 est alors raccordé à ses sources d'alimentation 4, 105, aux moyens de communication externes qu'il est susceptible d'alimenter, aux motorisations des interrupteurs 5 à alimenter et contrôler, ainsi qu'aux autres modules 200, 300, 400 de l'équipement de télé-conduite 10 ; comme indiqué, de préférence, l'atelier d'alimentation 100 n'est raccordé pour l'alimenter qu'au module de communication 200, qui transmettra l'énergie de proche en proche de préférence par un système de cavalier 240. L'atelier d'énergie 100 est par ailleurs relié audit module de communication 200 par une liaison 180 dédiée Modbus pour les échanges d'informations spécifiques concernant la surveillance et la commande inhérents à l'équipement de télé-conduite 10.

De fait, c'est le deuxième module 200 qui relie les modules de surveillance 300, 400 entre eux ainsi qu'avec le monde extérieur : cet élément 200 interagit dans la communication amont (vers un centre de contrôle SCADA 8, vers un technicien, vers un système de stockage) mais aussi dans la communication aval, c'est-à-dire la communication inter-modules de surveillance 300, 400, avec l'atelier d'énergie 100, avec des équipements 5, 9 tiers dans la sous-station 6.

Comme dans les offres classiques de télé-conduite pour la gestion des réseaux d'électricité MT 3, les moyens de communication 200 peuvent utiliser plusieurs médias (Ethernet, USB, GPRS, 3G, radio,...) et plusieurs protocoles (selon des standards IEC, ou Modbus/TCP, ou même en cyber-sécurité conforme à la norme IEC 62351), afin de donner un accès aux mesures et informations distantes, ainsi que de passer les ordres vers les interrupteurs 5 en vue de reconfigurations (suite à un défaut, un changement de schéma d'exploitation sur maintenance, un délestage de départs avant surcharge d'un transformateur...). Les moyens de communication 200 mis en œuvre peuvent gérer la communication distante vers le centre de contrôle 8, la communication locale pour des besoins de configuration sur site, de maintenance, ou encore les échanges avec d'autres équipements situés dans la même sous-station 6, comme une passerelle, avec notamment un maillage pour les échanges internes du produit 10.

Ici en outre, les moyens de communication sont logés dans un même boîtier 250 formant un module de communication 200, dont le profil sera similaire à celui des autres modules conformément à la figure 4, et dont la largeur est classiquement supérieure au pas, notamment 90 mm.

De fait, selon un mode de réalisation préféré, les fonctions assurées par le module de communication 200 sont séparées en deux blocs : la communication amont qui concerne la transmission de l'information notamment à un système de gestion centralisée 8 ou à une radio 24 ou autre, et le reste, assimilé à de la communication aval, qui concerne ainsi toute la communication entre les modules de l'équipement de télé-conduite 10 ainsi qu'avec des éléments du poste MT/BT 6.

La communication amont est déterminée par le client de l'équipement 10, selon ses choix de protocole et de médium (comme par exemple une communication par réseau téléphonique commuté, ou GSM, ou radio ; communication 3G ou FSK) et peut évoluer avec la mise à jour des protocoles ou appareillages dédiés. Selon un mode de réalisation préféré de l'invention, les éléments relatifs à la communication amont, c'est-à-dire *in fine* la « traduction » pour transférer les données en réception ou en émission, sont mis en œuvre dans des cassettes 252 amovibles du module de communication 200. Ainsi, selon l'implantation de l'équipement 10 et/ou sa mise à jour, une cassette 252 appropriée est choisie, insérée dans un logement 254 adapté du boîtier 250 de façon à ce que la communication puisse immédiatement être assurée selon le bon protocole. Les cassettes 252 comprennent les moyens nécessaires à leur fonction, associés selon les cas à des isolements, et de préférence une interface homme/machine 256 similaire entre elles, indiquant notamment le défaut de communication, la transmission et la réception, ainsi que certaines fonctions spécifiques (comme une diode électroluminescente d'attachement pour la cassette GSM), un moyen de connexion filaire 258 ou éventuellement une antenne 258'. Avantageusement, le boîtier 250 du module de communication 200 comprend deux fentes 254 d'insertion de cassette 252, dont une peut rester inutilisée, augmentant ainsi la largeur du module 200 mais permettant plus de flexibilité et de possibilité d'utilisation, tout en offrant une possibilité de redondance en cas de défaillance d'un des média.

La communication aval est quant à elle mise en œuvre par des moyens électroniques appropriés, en particulier un ensemble 260 de cartes électroniques par exemple dédiées chacune à des fonctions ou blocs de fonctions. De préférence, afin de permettre une adaptation des moyens de communication 200, voire même des modules de surveillance 300, 400 et d'alimentation 100 qui y sont reliés, l'ensemble électronique 260 comprend un microprocesseur adapté pour fournir différents services et qu'il est possible de mettre à jour et/ou reconfigurer depuis l'extérieur.

En particulier, l'ensemble de cartes 260 porte les moyens adaptés pour :
- la gestion des mises à jour ;
- la gestion des interruptions et défaillances (démarrage, tests, analyse post-défaillance) ;
- la gestion des alimentations, des entrées/sorties, dont les voyants externes et éventuelles sondes de températures, des interfaces homme/machine, ainsi que de la puissance, permettant de contrôler la consommation du module ainsi que les informations données ;
- la mise en œuvre d'une cyber-sécurité ;
- la gestion des cassettes 252 de communication ;
- l'implémentation de communication annexe, comme des communications WiFi ou USB ou réseau local Ethernet (LAN pour « *Local Area Network* ») vers par exemple un serveur Web basique fournissant une vue d'ensemble des données internes du module pour l'installation ou la maintenance, ou vers un appareil « esclave » à gérer ;
- et bien entendu la communication avec les autres modules 100, 300, 400 de l'équipement de télé-conduite 10.

L'agencement des cartes de l'ensemble 260 est réalisé pour s'intégrer dans un boîtier 250 dont une partie doit pouvoir rester « vide », formant les logements 254 de réception des cassettes 252 qui peuvent ou non être délimités par des parois de boîtier. Le boîtier 250 est ainsi clipsé en plusieurs parties 250A, 250B, 250C autour de l'ensemble électronique 260, avec de préférence un nez 52 d'interface amovible. Les moyens de raccordement de l'ensemble électronique 260 débouchent du boîtier par le côté oblique 50 mentionné plus haut ; au vu de la présence des logements 254, ledit côté oblique 50 de raccordement peut n'être présent que sur une partie de l'épaisseur du module 200 en prolongement du nez 52 et de l'interface homme/machine ; l'autre partie, située au niveau des cassettes 252, peut être simplifiée, et est destinée plutôt aux raccordements vers des équipements tiers 262 ou vers le réseau étendu WAN 262' (« *Wide Area Network* »), indépendants du fonctionnement proprement dit de l'équipement de télé-conduite 10. Un port USB 264 peut par ailleurs être prévu, pour étendre la mémoire du microprocesseur ou pour une caméra vidéo : la connexion ponctuelle est de préférence mise en place sur une partie de l'ensemble de cartes 260 accessible au niveau des logements 254 de cassettes 252.

Hors les moyens de communication sans fil, comme une connexion WiFi, et éventuellement à l'exception des moyens de raccordement câblé 262, 264 vers des équipements tiers, les moyens de raccordement et de visualisation de l'ensemble électronique 260 débouchent de préférence tous du boîtier 250 sur sa face inférieure 44, avec notamment : le port Modbus 266 de liaison avec l'atelier d'énergie 100, des entrées/sortie 268 pour capteurs (comme une sonde de température ou un capteur de porte) ou relais, ...

Les deux ports de communication 205, respectivement d'alimentation 245, communs aux modules 200, 300, 400 sont mis en place sur la partie frontale 46, respectivement de fond 48, de la paroi inférieure 44, l'un des ports 205, 245 au moins localisé à la distance prédéfinie du bord du boîtier 250 qui viendra se mettre côte à côte avec un module de surveillance 300, 400 afin d'utiliser les cavaliers de connexion 210, 240 ; le deuxième port de communication 205' est destiné à fermer la boucle de communication par un câble Ethernet et le deuxième port d'alimentation 245' est destiné à un raccordement avec l'atelier d'énergie 100 : ils peuvent donc être situés à une distance différente, les cavaliers de connexion 210, 240 ne pouvant pas être utilisés. Il apparaît ici avantageux que la partie de boîtier comprenant les fentes 254 soit la partie située en tête de rangée de l'équipement de télé-conduite 10.

L'interface homme/machine 270 du module de communication est adaptée pour permettre à l'utilisateur de visualiser le statut des différentes fonctionnalités mises en œuvre dans et par le module de communication 200, notamment via des diodes électroluminescentes, comme le statut des fonctions de communication (présence WiFi, alarme...), le statut des fonctions principales du module d'alimentation 100 (présence des différentes tensions, défaut de batterie...), le fonctionnement des autres modules... Des boutons poussoirs permettent l'activation ou l'inhibition, ainsi que la réalisation manuelle d'automatismes réseau tels que des dispositifs de permutation de source.

De plus, le module de communication 200 selon le mode de réalisation préféré est configuré pour pouvoir lui-même communiquer avec un outil externe permettant une mise à jour des logiciels et de certaines configurations : un port USB 272 pour la connexion d'un outil de configuration est intégré, de préférence sur la face avant et l'interface homme/machine 270. Avantageusement, le port USB 272 est caché par un joint souple amovible et imperdable 274. Certaines des diodes peuvent éventuellement être configurables par l'intermédiaire du microprocesseur via le port USB 272.

Cette fonctionnalité offerte par le port USB 272 et la reconfiguration permet également la récupération distante de données telles que des historiques d'événements, d'alarmes, de mesures, en vue de diagnostics suite à des événements sur le réseau électrique, ce qui offre aussi des possibilités de suivi et de gestion matérielle du parc installé. Cette option, ainsi que le choix de cassettes de communication amont 252, permet de faire évoluer le module de communication 200, et plus généralement l'appareil de télé-conduite 10, en fonction des avancées technologiques (telle la définition de nouveaux protocoles de communication), des desiderata clients (comme vers les téléphones intelligents), mais aussi en fonction des modifications architecturales du réseau 1, en pouvant prendre en compte l'addition de nouveaux modules de surveillance 300, 400 ou autres. Bien qu'ouverte à ces évolutions futures, l'offre reste fiable et sûre, notamment en termes de cyber-sécurité du fait que toutes les communications passent par le module dédié 200.

De fait, outre les communications vers l'extérieur et le module d'alimentation 100, le module de communication 200 gère bien entendu les informations nécessaires à la télé-conduite du réseau MT 3. Il reçoit les données recueillies par le(s) module(s) de surveillance MT 300 et leur transmet les éventuelles informations nécessaires à la gestion du réseau 3 : de fait, une offre de télé-conduite est destinée à détecter les dysfonctionnements, notamment de type court-circuit, dans le(s) réseau(x) MT 3, et à intervenir sur le réseau grâce à au moins un interrupteur 5 pour par exemple isoler la section du réseau en défaillance, et reconfigurer le réseau 3 pour minimiser le nombre de clients impactés par l'incident. En particulier, lorsque les interrupteurs 5 sont motorisés, le module d'alimentation 100 est adapté pour alimenter leur manœuvre (via par exemple une transformation et un raccordement 24 ou 48 V) de même que le module de communication 200 peut envoyer l'indication au module de surveillance 300 concerné pour un actionnement ; alternativement, l'alimentation pourrait être réalisée via le module de contrôle/commande 300 ou le module de communication 200 sous réserve d'une liaison, par exemple également en daisy chain, d'alimentation 24 ou 48 V.

Plus généralement un équipement de télé-conduite comprend des moyens de contrôle/commande MT aptes à réaliser les fonctions demandées sur les voies, c'est-à-dire l'une des lignes comprenant un des interrupteurs 5 tels qu'illustrés en figure 1A, qu'ils surveillent via des liaisons avec des capteurs MT 7 qui y sont placés, à savoir :
- détection des défauts de type court-circuit (phase-phase ou phase-terre) ;
- gestion de la présence/absence réseau ;
- gestion de la position de l'interrupteur 5 ;
- commande (locale ou distante) de l'interrupteur 5 à la fermeture et à l'ouverture ;
- prise en compte éventuelle d'automatismes réseau tels qu'un Permutateur Automatique de Source d'Alimentation PASA ou un Automatisme Décentralisé Alarmé (ADA) ;
- surveillance des courants et tensions MT, puissances et énergies.

Selon le mode de réalisation préféré de l'invention, pour tirer au mieux parti de l'architecture modulaire de l'équipement de télé-conduite 10, chaque module de contrôle/commande 300 ne surveille qu'une voie : ceci facilite les raccordements en évitant les erreurs de branchement ; de plus, bien que la prescription usuelle soit de classiquement 4 voies (avec une arrivée principale et une arrivée de secours vers un poste MT/BT 6 ainsi qu'un départ vers un poste suivant et éventuellement un vers un autre poste), *in fine*, peu de voies sont utilisées dans la pratique ce qui entraîne un encombrement et un coût inutiles avec les appareils prévoyant cette prescription par défaut. De plus, les boîtiers 310 des modules de contrôle/commande MT mono-voie 300 sont suffisamment étroits pour pouvoir en aligner facilement trois/quatre sur le module d'alimentation 100 si besoin.

Par ailleurs, il est connu que les moyens et méthodes pour détecter les défauts dépendent de nombreux facteurs : réseau aérien ou souterrain, réseau trois ou quatre fils, mise à la terre du neutre du réseau, existence d'un réseau secondaire, présence ou non de capteurs de courant et/ou tension MT 7. De plus, le type lui-même des capteurs 7 varie selon les réseaux 3, tout comme les interrupteurs 5 peuvent être motorisés ou non. Selon le mode de réalisation préféré de l'invention, les moyens électroniques de traitement du signal capté pour le module de surveillance 300 sont adaptés pour être configurés en fonction du réseau d'implantation : ils peuvent comprendre un ou plusieurs algorithmes de détection de défaut, de préférence parmi ceux décrits dans les document EP 2169799 ou EP 2687860 par exemple, avec des moyens de sélection au moment de l'implantation ; alternativement, les algorithmes peuvent être mis à jour par l'intermédiaire d'une liaison comme un port USB accessible en retirant le nez 52, ou via le module de communication 200.

Le microprocesseur propre à la fonction du module de surveillance MT 300 utilise avantageusement un système identique à celui du module de communication 200, notamment en ce qui concerne les gestionnaires de configuration, puissance, test, mise à jour, maintenance pour analyser les défaillances.

En particulier, les moyens électroniques comprennent une carte de courant avec les moyens de raccordement adaptés 322, une carte de tension avec les moyens de raccordement adaptés 324, et une carte de commande d'interrupteur 5 munie des moyens de raccordement adaptés 326, éventuellement associée à des moyens de commande du moteur associé 328. Les moyens de détermination de la commande d'interrupteur, c'est-à-dire de détection de défaut, peuvent faire l'objet d'une carte dédiée, ou être implantés dans la carte de commande, ou autre solution ; une connexion pour la mise à jour/la sélection peut être prévue directement sur le module de contrôle/commande MT 300 (notamment en retirant le nez 52) ou via le module de communication 200. De fait, bien entendu, le boîtier 310 loge également les éléments adaptés pour l'alimentation 245 et la communication 205, notamment par daisy chaining.

Le module de surveillance MT 300 comprend lui aussi une interface homme/machine, de préférence associée à un nez 52 de boîtier 310. L'interface homme/machine 340 est adaptée pour permettre à l'utilisateur de visualiser le statut de différentes fonctionnalités mises en œuvre dans et par le module de surveillance MT 300, notamment via des diodes électroluminescentes 342, comme des états, des alarmes, des statuts d'automate réseau, de contrôle local ou distant... L'interface homme machine 340 schématise de préférence le réseau 344 en indiquant les statuts des différents éléments (sectionneur de terre, interrupteur, présence tension) par des moyens de couleur. Des boutons poussoirs 346 permettent l'activation ou l'inhibition, ainsi que la réalisation manuelle d'ordre local sur l'interrupteur MT 5 associé. Certaines des diodes 342 peuvent éventuellement être configurables par l'intermédiaire du microprocesseur via le port USB ou via le module de communication 200.

Ainsi, l'équipement de télé-conduite 10 comprend des modules de surveillance, voire commande, 300 standardisés, qui sont adaptables sur tout réseau 1, 3 de façon simplifiée, que ce soit au niveau du nombre de modules 300ᵢ à utiliser ou du système de détection de défaut et de contrôle/commande à mettre en œuvre.

Par ailleurs, l'équipement de télé-conduite selon un mode de réalisation préféré de l'invention permet également de surveiller le réseau BT 4. De fait, dans le domaine de la télé-conduite des réseaux de distribution électriques 1, seule la gestion du réseau MT 3 est usuellement considérée, les enjeux étant principalement la continuité et la qualité de distribution : comme un défaut en BT 4 n'impacte qu'un nombre très limité de clients, contrairement au même défaut en MT 3, seule une observation passive du réseau BT 4 est parfois mise en œuvre, le plus souvent par agrégation des données issues des compteurs clients. Il apparaît cependant qu'au vu des enjeux relatifs à l'efficacité énergétique, à l'intégration des énergies renouvelables dispersées, l'équilibrage des phases ou la gestion du plan de tension BT peuvent devenir cruciaux.

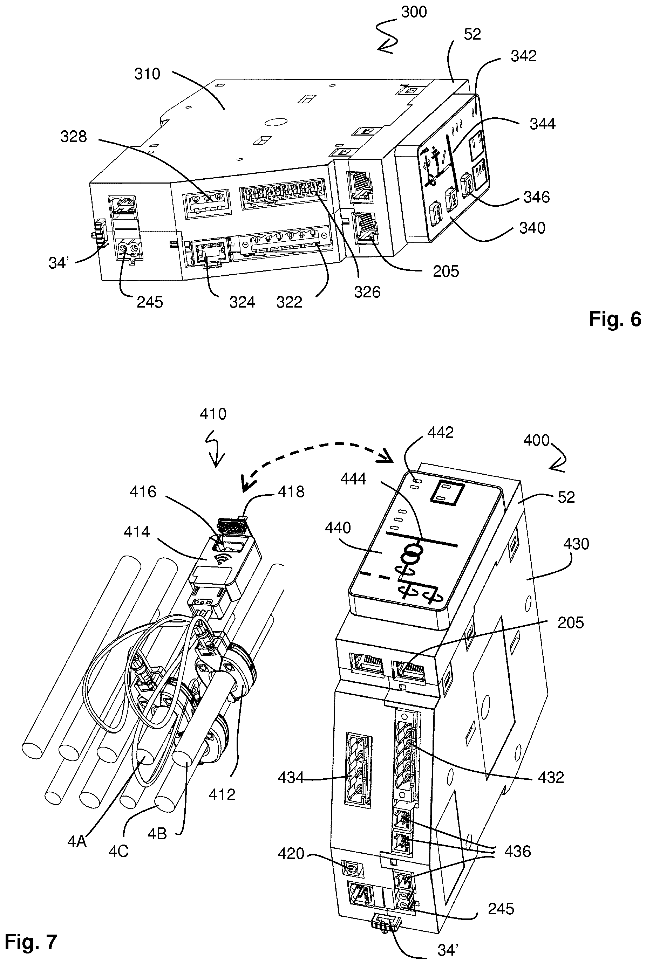

La cohabitation au sein d'un même produit des fonctions MT et BT est classiquement exclue pour des raisons d'isolement : typiquement un isolement de 10 kV est demandé entre les groupes MT et BT. Dans l'équipement de télé-conduite 10 selon l'invention, les fonctions de surveillance du réseau BT 4 sont intégrées en utilisant des capteurs BT autonomes 410 et qui communiquent sans fil, de préférence selon le protocole ZigBee. Ainsi, l'isolement entre les groupes de modules constituant l'architecture est respecté. Tel qu'illustré en figure 7, les capteurs 410 utilisés sont de préférence sous la forme de triplets de tores 412 ouvrants dont chacun peut se mettre en place sans interrompre le réseau sur un des câbles de la voie, en étant notamment adapté pour des câbles 4A, 4B, 4C jusque 27 mm. De préférence, les trois tores 412 d'un ensemble de capteurs 410 sont associés à une base de communication 414, qui peut également comprendre une interface 416 de visualisation, par exemple pour vérifier le statut de la communication Zigbee. Avantageusement, les éléments propres à la configuration pour l'appairage d'échange de données sans fil via le protocole Zigbee ainsi que les points d'accès lors des tests en production sont masqués sous un joint amovible 418.

Les données d'un ensemble de capteurs 410 sont transmises au module de surveillance BT 400 qui comprend ainsi des moyens de réception ZigBee 420 internes à son boîtier 430 ; de préférence, le module de surveillance BT 400 comprend en outre des moyens de raccordement 432 à un capteur de courant filaire 9' surveillant les courants du secondaire du transformateur MT/BT, afin d'en assurer une mesure continuelle pour permettre les fonctions de monitoring du transformateur, contrairement aux capteurs 410 qui peuvent présenter une éventuelle discontinuité de mesure communiquée au module 400, en raison d'un niveau de courant insuffisant pour garantir l'auto-alimentation.

Pour remplir ses fonctions, le module de surveillance BT 400 comprend également des moyens de raccordement 434 vers un capteur de tension du réseau BT 4, ainsi que de préférence des moyens de raccordement 436 vers des sondes de température. De fait, le module de contrôle/commande du réseau BT 400, outre servir de passerelle de communication Zigbee pour ses capteurs 410, est adapté pour remplir certaines des, ou toutes les, fonctions suivantes :
- gestion des capteurs 410 ;
- mesures de courants, tensions, puissances (ou facteur de puissance) et énergies (active, réactive et apparente ; totale et par phase) conformes aux normes indiquées au niveau de l'arrivée et des départs BT 4, pour une meilleure gestion et un meilleur équilibrage du plan de charge ;
- détection de neutre coupé, de présence/absence de tension, d'une fusion fusible BT;
- surveillance de l'équilibrage des charges ;
- enregistrement des formes d'onde ;
- indication de passage de défaut BT de type court-circuit, quel que soit le câble 4A, 4B, 4C et pour tout système de mise à la terre ;
- détection MT d'un défaut terre résistant ou d'un conducteur rompu selon le principe décrit dans le document FR 2976363 par exemple ;
- mesure de la fréquence réelle BT.

A cette fin, le module de surveillance BT 400 loge dans son boîtier 430, de forme similaire à celle du boîtier 310 de surveillance MT et comprenant bien entendu les moyens de raccordement 205, 245 pour les daisy chainings de communication et d'alimentation, ainsi qu'éventuellement un port de mise à jour USB, accessible notamment en retirant le nez 52, et des moyens électroniques, notamment sous forme de carte, aptes à remplir les fonctions ci-dessus.

Les moyens électroniques du module de surveillance BT 400 peuvent être adaptés pour être mis à jour ou modifiés grâce à un microprocesseur tel que décrit en relation avec le module MT 300, également via une communication directe par le module de communication 200. Outre ces fonctionnalités propres au module de surveillance BT 400, les moyens électroniques comprennent de fait, comme pour le module de surveillance MT 300, des moyens pour démarrer le module 400, des moyens permettant la gestion des mises à jour et configuration du processeur, des moyens pour réagir à une défaillance hardware, via un autotest, des moyens pour contrôler la consommation du module par rapport au mode d'alimentation (batterie 105 ou réseau 4) de l'équipement 10, des moyens pour analyser après défaillance les événements internes et donner un diagnostic, des moyens pour communiquer avec les autres modules, voire des moyens pour donner à un serveur distant une vue d'ensemble des données internes du module 400.

Parmi les fonctions à implémenter, il est possible également de donner des informations sur le transformateur du poste 6, informations qui seront communiquées au gestionnaire central 8, comme la mesure de sa température, la prédiction de sa fin de vie par surveillance des température et charge, le contrôle de la position de son réglage par surveillance du niveau de tension BT.

De plus, du fait de l'implémentation de la mesure et la surveillance des courants BT et MT au sein du même équipement de télé-conduite 10, la détection de la fusion fusible du transformateur est facilitée, les courants BT et MT étant disponibles directement via la communication 205 : cette détection peut être implémentée dans le module BT 400 et/ou MT 300 ou directement dans le contrôleur central 8.

De préférence, les moyens électroniques sont adaptés pour synchroniser les signaux issus des moyens de réception 420 afin de pouvoir gérer la pluralité de départ, et par exemple de mettre en œuvre le procédé décrit dans la demande de brevet FR 13 61222 permettant le monitoring de puissances et d'énergies sur la pluralité de départs BT avec une seule mesure de tension. Ainsi, il est possible de concentrer le contrôle de plusieurs voies BT sur le même module 400.

Par ailleurs, si l'arrivée du tableau BT et/ou les départs 4 sont équipés d'interrupteurs et disjoncteurs 9, il peut être possible de les contrôler via une communication dédiée, par exemple par le daisy chain ou des commandes intégrées via le modules de communication 200. Le module de contrôle/commande BT 400 comprend enfin lui aussi une interface homme/machine, de préférence associée à un nez 52 de boîtier 430. L'interface homme/machine 440 est adaptée pour permettre à l'utilisateur de visualiser le statut des différentes fonctionnalités mises en œuvre dans et par le module de surveillance BT 400, notamment via des diodes 442 électroluminescentes, comme des états, des alarmes, le statut de communication Zigbee... L'interface homme/machine 440 schématise de préférence le réseau 444 en indiquant les statuts des différents éléments (sectionneur de terre, interrupteur, présence tension) par des moyens de couleur.. De préférence, l'interface homme/machine 440 du module basse tension 400 se présente sous la même forme que l'interface 340 du module MT 300, à l'exception des boutons poussoirs 346, afin de simplifier l'interprétation des données par l'utilisateur.

Ainsi, grâce aux choix technologiques selon le mode de réalisation préféré, il est possible d'intégrer une fonction de surveillance jusqu'à douze départs BT triphasés dans un équipement de télé-conduite 10 avec un seul module de surveillance BT 400. Les problèmes d'isolement sont notamment résolus en ayant recours à des capteurs auto-alimentés communiquant sans fil.

Plus généralement, les différentes options prises dans le mode de réalisation préféré permettent de fournir un équipement 10 de télé-conduite satisfaisant les nouveaux enjeux des réseaux 1 de distribution électrique modernes et « intelligents » (ou « *Smart Grids* »). L'offre modulaire présentée facilite la cohérence de gamme entre les différents contextes applicatifs (réseau souterrain vs. aérien, prise en compte des ressources d'énergie distribuées, supervision étendue du domaine MT au domaine BT...), tout en conservant des possibilités d'évolution, tant sur le plan logiciel que matériel. Les choix de modularité logicielle et matérielle sont répercutés sur la mécanique des différents éléments constitutifs, mais aussi leur agencement (distribution de l'alimentation par exemple) et leur inter-opérabilité (échanges des informations entre modules).

En particulier, l'équipement de télé-conduite 10 comprend des moyens d'alimentation 100, des moyens de communication 200, des moyens de surveillance MT 300 et des moyens de surveillance BT 400. Chacun de ces moyens 100, 200, 300, 400 est de préférence logé dans un boîtier fonctionnel 110, 250, 310, 430, ces modules étant au format DIN et présentant le même profil 30 pour ceux qui sont alignés, facilitant ainsi leur assemblage et optimisant le câblage de la connectique de la solution, qui est avantageusement réalisé par des cavaliers Ethernet 210 similaires entre eux pour la majorité des connexions : la solution n'est ni figée ni contrainte par un coffret 20, tout en étant considérée comme « banale » dans la mise en œuvre.

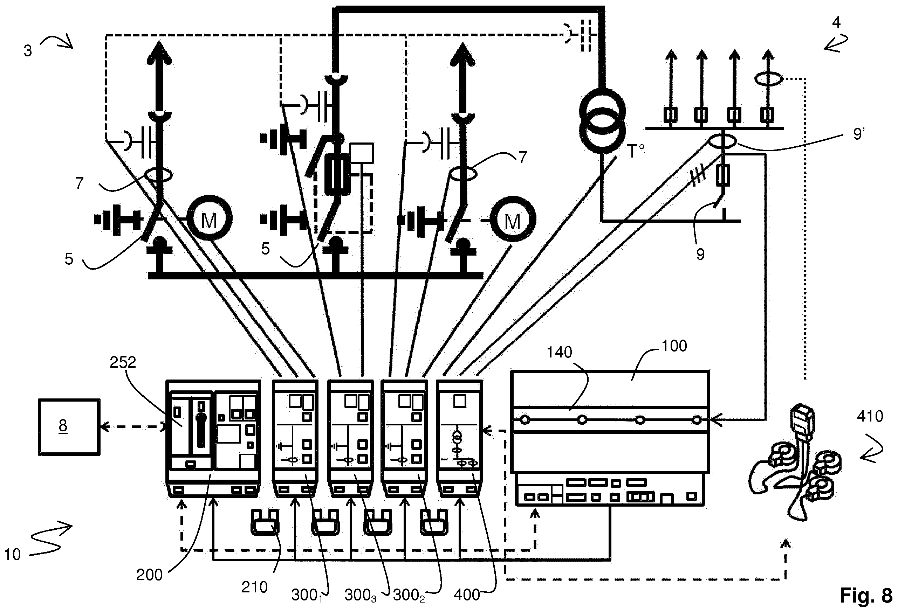

Notamment, la solution proposée et illustrée dans un mode de réalisation en figure 8 s'articule autour :
- d'un atelier d'alimentation 100 qui alimente l'ensemble des fonctions (électronique, radio/GSM, motorisation des interrupteurs) avec le niveau de tension requis, à partir du réseau BT 4 et d'une source auxiliaire assurée par une batterie 105 dont il assure la gestion (charge, surveillance) ; le boitier 110 de cet atelier d'énergie 100 sert de support mécanique aux autres modules, en intégrant un rail DIN 140 en face avant ;
- d'un module de communication 200, qui connecte les modules entre eux, mais aussi avec le monde extérieur (vers le centre de contrôle 8, vers le « *cloud* » et des applicatifs de stockage de données pour du monitoring, vers un ordinateur pour le personnel technique, vers un équipement tiers dans la sous-station 6...) ; ce module supporte différents types de communication et différents protocoles, et assure les fonctions de cybersécurité ; il supporte en outre la base de données, et les fonctionnalités système grâce à un atelier d'automate de logique programmable ;
- d'au moins un module 300ᵢ de contrôle et commande d'interrupteurs MT 5 qui supporte toutes les fonctions relatives à un départ MT 3 ;
- d'au moins un module de surveillance BT 400 associé à une unité de capteurs auto-alimentés et communiquant sans fil 410, ou plusieurs.

L'alimentation des modules 200, 300, 400 ainsi que la communication entre eux sont de préférence réalisées par daisy chaining, ce qui augmente encore les possibilités d'évolution et d'adaptation, tout en facilitant l'installation et la mise en œuvre. Les exigences relatives à la cyber-sécurité et l'encryptage des données peuvent par là être directement intégrées dans le module de communication 200 qui gère l'ensemble des échanges. De plus, les différents moyens de mise en œuvre du contrôle, de la surveillance, de la commande, et de la communication sont prévus pour pouvoir être adaptés au besoin du client sur site, en fonction du réseau (y compris s'il est à flux bidirectionnel) grâce à des facilités logicielles, et mis à jour via une plateforme commune, notamment un processeur dans le module de communication 200 qui peut être connecté à tout outil de configuration, de sorte que l'équipement 10 peut intégrer les nouvelles fonctionnalités développées au cours de sa vie. Dès l'installation, l'équipement 10 comprend dans tous les cas de préférence les moyens pour utiliser les différents médias et protocoles de communication disponibles, en offrant un meilleur débit, une bande passante accrue et des possibilités de redondance en cas de défaillance d'un réseau de communication. La connexion avec des équipements tiers est prévue, tout comme un stockage accru des données (mesures, historisation des événements, des alarmes), de manière locale et/ou de manière distante, via des transferts et des sauvegardes périodiques.

Dans le mode de réalisation préféré, en outre, une gestion optimisée de la consommation de l'équipement 10, par utilisation de modes « économie d'énergie » sur les microprocesseurs ou recours à des principes d'auto-alimentation, est intégrée. De plus, les systèmes électroniques mis en œuvre dans les différents modules 100, 200, 300, 400 peuvent prendre en compte la définition de logiques de contrôle localisées, afin d'assurer de nouvelles fonctionnalités curatives (telle que l'auto-cicatrisation suite à un défaut) ou préventives (telles que du délestage de charges en cas de pic de consommation, ou la possibilité de s'appuyer sur la production décentralisée à proximité pour soulager le réseau principal), sans nécessairement devoir remonter systématiquement jusqu'au centre de conduite 8.

## Revendications

1. Equipement de télé-conduite (10) **caractérisé en ce qu'**il comporte :
- un module d'alimentation (100), ledit module d'alimentation (100) comprenant un boîtier (110) logeant des moyens électroniques (150) qui :
- comprennent des moyens de raccordement (170) à un réseau basse tension (4), des moyens de raccordement (172) à une batterie (105), des moyens (245) de raccordement pour alimenter des modules électroniques (200, 300, 400), et
- sont adaptés pour transformer l'énergie du réseau (4) et de la batterie (105) auxquels ils peuvent être raccordés en énergie d'alimentation des modules électroniques (200, 300, 400) auxquels ils peuvent être raccordés, le boîtier (110) :
- comprenant une face de support (120) destinée à être fixée sur un support mural,
- étant fermé pour une première partie (114) par un couvercle (132) présentant une face avant (134) opposée à la face de support (120) et dotée de moyens de fixation (140) pour des modules électroniques (200, 300, 400), et pour la seconde partie (112) par un capot (142) comprenant des orifices (144) depuis lequel sont accessibles les moyens de raccordement (170, 172, 174, 245) des moyens électroniques (150),
- au moins un module de surveillance (300) d'un réseau moyenne tension (3), ledit module de surveillance (300) étant mis en place sur la face avant (134) du couvercle (132) du module d'alimentation (100) via les moyens de fixation (140) et étant relié au module d'alimentation (100) par l'intermédiaire des moyens (245) de raccordement pour alimenter des modules électroniques du module d'alimentation (100),
- un module de communication (200) mis en place sur la face avant (134) du couvercle (132) du module d'alimentation (100) via les moyens de fixation (140) et raccordé aux moyens (245) de raccordement pour alimenter des modules électroniques du module d'alimentation (100), ledit module de communication (200) étant par ailleurs relié au module de surveillance (300) de sorte que la liaison entre le module de surveillance (300) et le module d'alimentation (100) soit sous forme de connexion en série via le module de communication (200), et **en ce que** :
- le module de communication (200) est relié audit module de surveillance (300) par une liaison série utilisant un cavalier rigide.

2. Equipement de télé-conduite (10) selon la revendication 1 dans lequel le couvercle (132) et la face de support (120) sont métalliques, le capot (142) est isolant.

3. Equipement de télé-conduite (10) selon la revendication 2 comprenant des moyens d'isolation (146, 148) des moyens électroniques (150) par rapport au couvercle (132) et à la face de support (120).

4. Equipement de télé-conduite (10) selon l'une des revendications 1 à 3 dans lequel les moyens électroniques comprennent une carte de circuit imprimé (150) qui se loge parallèlement à la face de support dans le boîtier (110).

5. Equipement de télé-conduite (10) selon la revendication 4 dans lequel la carte de circuit imprimé (150) comprend en outre un port de communication (180), le capot (142) comprenant un orifice d'accès audit port (180).

6. Equipement de télé-conduite (10) selon la revendication 5 dans lequel la carte de circuit imprimé (150) comprend en outre des moyens de visualisation (176), le deuxième capot (142) comprenant des orifices adaptés pour lesdits moyens de visualisation (176).

7. Equipement de télé-conduite (10) selon l'une des revendications 1 à 6 dans lequel les moyens de fixation de la face avant (134) du couvercle (132) comprennent un rail DIN (140).

8. Equipement de télé-conduite (10) selon l'une des revendications 1 à 7 dans lequel la face de support (120) comprend des moyens de fixation (122) à deux rails parallèles.

9. Equipement de télé-conduite (10) selon la revendication 8 dans lequel les moyens de fixation comprennent des moyens d'encliquetage (122) sur un premier rail et des moyens de verrouillage (130) sur le deuxième rail.

10. Equipement de télé-conduite (10) selon l'une des revendications 1 à 9 dans lequel le couvercle (132) comprend deux parois latérales (136) munies d'ouïes de ventilation (138).

## Patentansprüche

1. Fernwirkeinrichtung (10), **dadurch gekennzeichnet, dass** sie beinhaltet:
- ein Versorgungsmodul (100), wobei das Versorgungsmodul (100) ein Gehäuse (110) umfasst, in dem elektronische Mittel (150) untergebracht sind, die:
- Anschlussmittel (170) zum Anschließen an ein Niederspannungsnetz (4), Anschlussmittel (172) zum Anschließen an eine Batterie (105), Anschlussmittel (245) zum Versorgen der elektronischen Module (200, 300, 400) umfassen und
- geeignet sind, die Energie des Netzes (4) und der Batterie (105), an die sie angeschlossen werden können, in Energie zur Versorgung der elektronischen Module (200, 300, 400), an die sie angeschlossen werden können, umzuwandeln, wobei das Gehäuse (110):
- eine Trägerseite (120) umfasst, die dazu ausgelegt ist, an einer Wandhalterung befestigt zu werden,
- für einen ersten Teil (114) mit einer Abdeckung (132) verschlossen wird, die eine Vorderseite (134) aufweist, die entgegengesetzt zur Trägerseite (120) ist und mit Befestigungsmitteln (140) für elektronische Module (200, 300, 400) ausgestattet ist, und für den zweiten Teil (112) mit einer Kappe (142), die Öffnungen (144) umfasst, durch welche die Anschlussmittel (170, 172, 174, 245) für die elektronischen Mittel (150) zugänglich sind,
- mindestens ein Überwachungsmodul (300) zum Überwachen eines Mittelspannungsnetzes (3), wobei das Überwachungsmodul (300) an der Vorderseite (134) der Abdeckung (132) des Versorgungsmoduls (100) über die Befestigungsmittel (140) angebracht ist und mit dem Versorgungsmodul (100) über Anschlussmittel (245) verbunden ist, um elektronische Module des Versorgungsmoduls (100) zu versorgen,
- ein Kommunikationsmodul (200), das an der Vorderseite (134) der Abdeckung (132) des Versorgungsmoduls (100) über die Befestigungsmittel (140) angebracht ist und an die Anschlussmittel (245) angeschlossen ist, um elektronische Module des Versorgungsmoduls (100) zu versorgen, wobei das Kommunikationsmodul (200) im Übrigen mit dem Überwachungsmodul (300) so verbunden ist, dass die Verbindung zwischen dem Überwachungsmodul (300) und dem Versorgungsmodul (100) in Form einer Reihenschaltung über das Kommunikationsmodul (200) vorliegt, und dadurch, dass:
- das Kommunikationsmodul (200) mit dem Überwachungsmodul (300) über eine serielle Verbindung verbunden ist, die eine starre Brücke verwendet.

2. Fernwirkeinrichtung (10) nach Anspruch 1, wobei die Abdeckung (132) und die Trägerseite (120) aus Metall sind, die Kappe (142) isolierend ist.

3. Fernwirkeinrichtung (10) nach Anspruch 2, umfassend Isolationsmittel (146, 148) zum Isolieren der elektronischen Mittel (150) gegenüber der Abdeckung (132) und der Trägerseite (120).

4. Fernwirkeinrichtung (10) nach einem der Ansprüche 1 bis 3, wobei die elektronischen Mittel eine Leiterplatte (150) umfassen, die parallel zur Trägerseite im Gehäuse (110) aufgenommen ist.

5. Fernwirkeinrichtung (10) nach Anspruch 4, wobei die Leiterplatte (150) ferner einen Kommunikationsport (180) umfasst, wobei die Kappe (142) eine Zugangsöffnung zu dem Port (180) umfasst.

6. Fernwirkeinrichtung (10) nach Anspruch 5, wobei die Leiterplatte (150) ferner Anzeigemittel (176) umfasst, wobei die zweite Kappe (142) geeignete Öffnungen für die Anzeigemittel (176) umfasst.

7. Fernwirkeinrichtung (10) nach einem der Ansprüche 1 bis 6, wobei die Befestigungsmittel der Vorderseite (134) der Abdeckung (132) eine DIN-Schiene (140) umfassen.

8. Fernwirkeinrichtung (10) nach einem der Ansprüche 1 bis 7, wobei die Trägerseite (120) Befestigungsmittel (122) mit zwei parallelen Schienen umfasst.

9. Fernwirkeinrichtung (10) nach Anspruch 8, wobei die Befestigungsmittel Einrastmittel (122) an einer ersten Schiene und Verriegelungsmittel (130) an der zweiten Schiene umfassen.

10. Fernwirkeinrichtung (10) nach einem der Ansprüche 1 bis 9, wobei die Abdeckung (132) zwei Seitenwände (136) umfasst, die mit Lüftungsschlitzen (138) versehen sind.

## Claims

1. Telecontrol equipment (10) **characterized in that** it includes:
- a power supply module (100), said power supply module (100) comprising a casing (110) housing electronic means (150) which:
- comprise means (170) for connecting to a low-voltage network (4), means (172) for connecting to a battery (105), connection means (245) for supplying electronic modules (200, 300, 400) with power; and
- are suitable for transforming the energy from the network (4) and from the battery (105) to which they can be connected into energy for supplying power to the electronic modules (200, 300, 400) to which they can be connected, the casing (110):
- comprising a support face (120) intended to be fixed onto a wall mount; and
- being closed for a first part (114) by a cover (132) having a front face (134) opposite the support face (120) and provided with attachment means (140) for electronic modules (200, 300, 400), and, for the second part (112), by a cap (142) comprising apertures (144) from which the connection means (170, 172, 174, 245) of the electronic means (150) are accessible;
- at least one monitoring module (300) for a medium-voltage network (3), said monitoring module (300) being installed on the front face (134) of the cover (132) of the power supply module (100) via the attachment means (140) and being connected to the power supply module (100) via the connection means (245) for supplying power to electronic modules of the power supply module (100);
- a communication module (200) installed on the front face (134) of the cover (132) of the power supply module (100) via the attachment means (140) and connected to the connection means (245) for supplying power to electronic modules of the power supply module (100), said communication module (200) also being connected to the monitoring module (300) such that the connection between the monitoring module (300) and the power supply module (100) is in the form of a series connection via the communication module (200); and **in that**
- the communication module (200) is connected to said monitoring module (300) by a series connection using a rigid jumper.

2. Telecontrol equipment (10) according to Claim 1, wherein the cover (132) and the support face (120) are metal, the cap (142) is insulating.

3. Telecontrol equipment (10) according to Claim 2, comprising means (146, 148) for insulating the electronic means (150) with respect to the cover (132) and to the support face (120).

4. Telecontrol equipment (10) according to one of Claims 1 to 3, wherein the electronic means comprise a printed circuit board (150) which is housed parallel to the support face in the casing (110).

5. Telecontrol equipment (10) according to Claim 4, wherein the printed circuit board (150) further comprises a communication port (180), the cap (142) comprising an aperture for access to said port (180).

6. Telecontrol equipment (10) according to Claim 5, wherein the printed circuit board (150) further comprises display means (176), the second cap (142) comprising orifices adapted for said display means (176).

7. Telecontrol equipment (10) according to one of Claims 1 to 6, wherein the attachment means of the front face (134) of the cover (132) comprise a DIN rail (140).

8. Telecontrol equipment (10) according to one of Claims 1 to 7, wherein the support face (120) comprises attachment means (122) with two parallel rails.

9. Telecontrol equipment (10) according to Claim 8, wherein the attachment means comprise snap-fitting means (122) on a first rail and locking means (130) on the second rail.

10. Telecontrol equipment (10) according to one of Claims 1 to 9, wherein the cover (132) comprises two side walls (136) provided with ventilation louvres (138).
